(19) Europäisches Patentamt
European Patent Office
Office européen des brevets

(11) EP 1 566 469 A2

(12) EUROPÄISCHE PATENTANMELDUNG

(43) Veröffentlichungstag:
24.08.2005 Patentblatt 2005/34

(51) Int Cl.$^7$: C30B 29/12, G02B 5/30

(21) Anmeldenummer: 05003902.3

(22) Anmeldetag: 23.02.2005

(84) Benannte Vertragsstaaten:
AT BE BG CH CY CZ DE DK EE ES FI FR GB GR HU IE IS IT LI LT LU MC NL PL PT RO SE SI SK TR
Benannte Erstreckungsstaaten:
AL BA HR LV MK YU

(30) Priorität: 23.02.2004 DE 102004008749

(71) Anmelder: Schott AG
55122 Mainz (DE)

(72) Erfinder:
• Ortmann, Lars, Dr.
07749 Jena (DE)

• Kandler, Jörg, Dr.
07751 Cospeda (DE)
• Menzel, Andreas
07745 Jena (DE)
• Müller, Matthias, Dr.
07745 Jena (DE)
• Parthier, Lutz Dr.
14532 Klein-Machnow (DE)
• von der Gönna, Gordon Dr.
07743 Jena (DE)

(74) Vertreter: Fuchs Mehler Weiss & Fritzsche
Naupliastrasse 110
81545 München (DE)

(54) **Verfahren zur Herstellung eines grossvolumigen CaF2-Einkristalles mit geringer Streuung und verbesserter Laserstabilität, sowie ein solcher Kristall und dessen Verwendung**

(57) Es wird ein Verfahren zur Herstellung von CaF$_2$-Einkristallen mit minimalen Brechzahlunterschieden und einer ungewöhnlich geringen Anzahl an Kleinwinkelkorngrenzen beschrieben, die auch noch nach Tempern mit erhöhter Temperatur nur eine geringe Streuung aufweisen. Bei dem Verfahren wird ein Kristall aus einer Schmelze durch Abkühlen und anschließendes Tempern hergestellt, wobei die CaF$_2$-Materialschmelze aus einem Material hergestellt wird, das bei einer Temperatur von mindestens 1100°C in einem Vakuum bei höchstens $5*10^{-4}$ mbar verdampft und bei einer Temperatur von 500-1280°C kondensiert. Das Verfahren wird vorzugsweise mit bereits gebrauchten Abfallmaterial und Verschnittmaterial aus verbrauchten Schmelzversuchen durchgeführt.

Figur 2

## Beschreibung

Die Erfindung betrifft ein Verfahren zur Herstellung von Großvolumigen $CaF_2$-Kristallen mit geringer Streuung sowie verbesserter erhöhter Laserstabilität, die bei erhöhter Temperatur temperbar sind und die eine besonders hohe Homogenität sowie geringe Kleinwinkelkorngrenzen und Spannungsdoppelbrechung aufweisen, ein Kristall, der mittels dem Verfahren erhältlich ist, sowie dessen Verwendung.

Zur Herstellung von elektronischen Rechenbauteilen, wie Computerchips sowie anderer integrierter Schaltkreise werden mittels optischer Lithographie Strukturen solcher Schaltkreise mittels einer Fotomaske auf einen Wafer abgebildet und dieser dabei belichtet. Der Bedarf an immer leistungsfähigeren Rechnern erfordert immer kleinere Rechenchips. Dies macht es notwendig, die jeweiligen Schaltkreisstrukturen immer schärfer abzubilden. Dies führt zwangsweise dazu, immer kleinere Wellenlängen zu verwenden. Inzwischen sind die Abbildungen sogar dünner und kleiner sind als die Wellenlänge des jeweils verwendeten Lichtes. So werden ausgehend von Laserlicht der Wellenlänge 365 nm über 248 nm inzwischen Wellenlängen von 193 nm und 157 nm genutzt um auf dem jeweiligen Wafer die Schaltkreisstrukturen möglichst scharf abzubilden. Darüber hinaus wurden zusätzliche Abbildungstechniken entwickelt, welche es ermöglichen, auch noch solche Strukturen scharf abzubilden, deren Linien kleiner sind als die Wellenlänge des jeweils verwendeten Lichtes. Hierzu gehören insbesonders die sog. Technologien zur verbesserten Auflösung (Resolution Enhancement Technology, RET), wie beispielsweise die OPC(optical Proximity Correction - Optische Näherungs-Korrektur), die Verwendung verschiedener off-axis Beleuchtungsarten, so genannte Phasen schiebende Masken (phase shift masks) und Doppelbelichtungssystem (double exposure systems). Diese Hochleistungstechnologien setzen jedoch voraus, dass die hierzu verwendeten optischen Linsensysteme sowie die darin verwendeten optischen Materialien immer höhere Qualitäten erreichen. In diesem Zusammenhang werden auch $CaF_2$-Einkristalle als Linsenmaterial gegenüber synthetischen Quarzglas zunehmend an Bedeutung gewinnen. Bei einer Arbeitswellenlänge von 157 nm kann dann letztlich nur noch $CaF_2$ verwendet werden, da Quarzglas für Licht dieser Wellenlänge nicht mehr durchlässig ist. Bislang wurden große $CaF_2$-Einkristalle im wesentlichen in der Belichtungsoptik, d. h. der Optik zur Belichtung der Fotomaske verwendet.

Es ist allgemein bekannt, dass die optischen Eigenschaften eines Kristalls ganz entscheidend von der Qualität des Kristalles abhängen. Dabei sind derartige Einkristalle Realkristalle, d.h. Kristalle deren reale Gitter von der theoretischen Idealstruktur abweichen und Baufehler aufweisen. Derartige Baufehler werden z.B. dadurch hervorgerufen, dass beim Wachstum vereinzelte Gitterstellen nicht besetzt werden, was zu sog. Fehlstellen, wie Punktdefekten oder auch Versetzungen wie linearen Defekten führt. Aber auch durch nicht vermeidbare Verunreinigungen mit Fremdionen, werden Störungen im Gittergefüge hervorgerufen. Die Qualität, d.h. die Perfektheit eines Kristalles ist abhängig von dem jeweils ausgewählten Zuchtverfahren und dessen Durchführung, d.h. insbesondere von Verfahrensparametern wie der Wachstumsgeschwindigkeit sowie den Temperaturen beim Züchten und beim Abkühlen. So hat es sich beispielsweise gezeigt, dass durch ein Tempern, d.h. durch Erwärmen eines fertig gezüchteten Kristalls über einen längeren Zeitraum bei hohen Temperaturen einige Baufehlerarten wie Kleinwinkelkorngrenzen und die durch unterschiedliche Gitterspannung hervorgerufene Spannungsdoppelbrechung drastisch verringert werden können. Es hat sich jedoch auch gezeigt, dass durch ein derartiges längeres Tempern regelmäßig die Lichtstreuung im Kristall stark zunimmt und zwar sowohl die Streuung des reflektierten als auch des durchtretenden Lichtes. Die Streuung des reflektierten Lichtes wird durch die sog. bidirektionale Reflektionsverteilungsfunktion (bi-directional reflection distribution function, BRDF) und die Streuung des den Kristall durchdringenden Lichtes wird mittels der sog. bidirektionale Transmissionsverteilungsfunktion (bi-directional transmittance distribution function, BTDF) beschrieben. Beide Streuungsarten lassen sich zur sog. bidirektionalen Streuungsverteilungsfunktion (bidirection scattering distribution function, BSDF) zusammenfassen. Diese BSDF wird zur quantitativen Beschreibung des Streuverhaltens von Prüflingen verwandt. Sie ist für senkrechten Lichteinfall eine Funktion vom Streulichtwinkel $\theta s$ und dem Streulichtazimutwinkel $\varphi s$ und beschreibt das Verhältnis von gemessener Streuleistung Ps in einem durch die Meßapparatur vorgegebenen Raumwinkelelement $d\Omega s$ bezogen auf die eingestrahlte Leistung Pi und ist nach Stover (siehe Stover J.C.; Optical scattering - measurement and analysis; McGraw-Hill, Inc. 1990) definiert mit:

$$BSDF = (Ps\,/\,\Omega s)\,/\,(Pi\,\cos\,\theta s).$$

Der Kosinusfaktor projektiert das beleuchtete Streuvolumen in Richtung des Streuwinkels $\theta s$ und ermöglicht somit einen direkten Vergleich zu Streulichtmessungen von Oberflächen. Die Einheit der BSDF ist 1/Steradiant. Für die Charakterisierung des Streulichtverhaltens transparenter Prüflinge wird die Leistung des Streulichts unter einem festen Streuwinkel $\theta s$ detektiert, so dass als quantifizierbare Streulichtkenngröße der BSDF-Wert für $\theta s$=konst. angegeben wird.

Ein Kristall mit einer bereits mit dem Auge visuell wahrnehmbaren Streuung, sei sie auch noch so gering, ist für die elektronische Lithographie, insbesondere für Abbildungsoptiken, nicht oder nur begrenzt brauchbar. Dabei ist sowohl die diffuse als auch die diskrete Streuung störend.

Üblicherweise lassen sich derartige Kristalle auf dem Fachmann bekannte vielfältige Art und Weise herstellen, wie beispielsweise den am häufigsten verwendeten Verfahren nach der Gradienten-Verfestigungsmethode (GSM-Verfahren)und dem Bridgman-Stockbarger-Verfahren.

Eine Untersuchung über die Perfektionierung der Herstellung von $CaF_2$-Einkristallen in Abhängigkeit von der Zuchttechnik ist beispielsweise von R. Leckebusch und K. Recker in Journal of Crystal Growth 13/14 (1972) 276-281 beschrieben. Darin wird auch berichtet, dass bei dampfgezüchteten Kristallen, bei denen auf einen Impfkristall dampfförmiges Kristallmaterial abgeschieden wird, an den (111)-Spaltflächen aufgrund der extrem kleinen Wachstumgeschwindigkeit sowie den kleinen Temperaturgradienten innerhalb des wachsenden Kristalls und dem verfahrensbedingten geringen Einbau von Verunreinigungen nur eine geringe Zahl von Versetzungen aufweisen. Mit diesem Verfahren sind jedoch aufgrund der langsamen Wachstumsgeschwindigkeit nur kleine Kristalle von wenigen mm Größe herstellbar und keine großvolumigen wie sie für die Verwendung in der Fotolithographie notwendig sind. Dafür werden nämlich großvolumige Kristalle mit einem Durchmesser von mindestens 20 bzw. 30 cm sowie einer Höhe von mindestens ebenfalls 10 bzw. 20 cm benötigt. Inzwischen steigt auch der Bedarf an Einkristallen mit noch wesentlich größerem Volumen.

Zudem fallen bei der bisherigen Linsenherstellung aufgrund von geometrischen Verschnitt sowie aus in ihren optischen Eigenschaften für die Lithografieanwendung nicht geeigneten Kristallen eine große Menge von bereits prozessierten, nicht weiter verwendbaren $CaF_2$-Kristallen als Abfall an, d.h. Material mit Kristallbaufehlern, schlechter Homogenität, zu großer Doppelbrechung sowie schlechter Transmission und/oder zu großer Streuung. Dieser Abfall muss dann aufwendig und kostenintensiv entsorgt werden.

Die Erfindung hat daher zum Ziel, ein Verfahren zur Herstellung von großvolumigen $CaF_2$-Einkristallen mit erhöhter Laserstabilität und geringer Streuung bereitzustellen, die auch bei erhöhten Temperaturen ohne störende Zunahme der Streuung temperbar sind und somit gleichzeitig eine erhöhte Homogenität und Spannungsdoppelbrechung erreicht werden können.

Die Erfindung hat des Weiteren zum Ziel, großvolumige $CaF_2$-Einkristalle bereitzustellen, die nicht nur in optischen Systemen zur Belichtung von Fotomasken, sondern auch zur Abbildung bzw. Projektion von Strukturen eingesetzt werden können.

Die Erfindung hat auch zum Ziel, derartige Kristalle aus nichtbrauchbarem verbrauchten $CaF_2$-Abfall aus ehemaligen Zuchtprozessen wieder zu verwenden.

Dieses Ziel wird mit den in den Ansprüchen definierten Merkmalen erreicht.

Es wurde nämlich überraschenderweise gefunden, dass sich besonders hochtemperbare streufreie, zumindest jedoch streuarme großvolumige $CaF_2$-Einkristalle aus einer Schmelze herstellen lassen, wenn das zur Herstellung der Schmelze verwendete Kristallrohmaterial zuvor bei einer Temperatur von mindestens 1100°C in einem Vakuum von höchstens $5*10^{-4}$ mbar verdampft und bei einer Temperatur von mindestens 500°C wieder kondensiert wird. Es hat sich nämlich erfindungsgemäß gezeigt, dass ein aus einer derartigen Schmelze hergestellter Kristall auch noch bei Temperaturen deutlich oberhalb der sonst beim Tempern eingesetzten Temperaturen einem die Homogenität fördernden und die SDB verringernden Heizprozeß unterzogen werden kann ohne dass dabei die Streuung im Kristall wesentlich zunimmt. Es hat sich auch gezeigt, dass bei der erfindungsgemäßen Vorgehensweise weder die diskrete noch die diffuse Streuung in nennenswertem Maße zunimmt. Mit dem erfindungsgemäßen Verfahren lassen sich daher Kristalle erhalten, welche verbesserte Streueigenschaften, weniger Kleinwinkelkorngrenzen und eine weit verbesserte Laserstabilität aufweisen. Darüber hinaus werden mit dem erfindungsgemäßen Verfahren Kristalle erhalten, die eine extrem hohe Homogenität und eine äußerst geringe Spannungsdoppelbrechung zeigen. Es versteht sich von selbst, dass die mit dem erfindungsgemäßen Verfahren erhaltene Kristalle auch beim Tempern bei geringeren Temperaturen verbesserte Streueigenschaften und Laserstabilität aufweisen als dies mit den bisherigen Verfahren möglich war.

In einer bevorzugten Ausführungsform wird erfindungsgemäß vor der Sublimation das Ausgangsmaterial wärmebehandelt. Bevorzugte Behandlungstemperaturen betragen mindestens 1000°C, vorzugsweise mindestens 1100°C und höchstens 1350°C, vorzugsweise 1300°C, wobei Maximaltemperaturen von 1250°C besonders bevorzugt sind. Eine derartige Wärmebehandlung wird über eine längere Haltezeit, insbesondere über einen Zeitraum von mindestens 5 Stunden, vorzugsweise mindestens 10 Stunden durchgeführt, wobei ein Zeitraum von mindestens 24 Stunden, insbesondere mindestens 48 Stunden besonders bevorzugt ist. Zweckmäßige Höchstzeiten betragen maximal 120 Stunden, wobei maximal 100 Stunden bevorzugt ist. Die erfindungsgemäße Wärmebehandlung dient unter anderem der maximalen Ausbildung von Ausscheidungen von Fremdstrukturen im Kristallgefüge des Ausgangsmaterials. Dabei kann das Kristallgefüge sowohl ein Einkristall als auch Polykristallin sein und zwar unabhängig von seiner Teilchengröße, d. h. das Material kann sowohl Kristallbruchstücke, als auch scherbenförmig oder pulverförmig sein.

Es versteht sich von selbst, dass bei der Wärmebehandlung bzw. diesem Vortempern im Wesentlichen keine Verdampfung des zu behandelnden Materials, insbesondere des $CaF_2$, erfolgt, bzw. die Wärmebehandlung so durchgeführt wird, dass eine Verdampfung des Kristallmaterials vermieden wird.

Erfindungsgemäß wurde nämlich gefunden, dass durch eine Kombination von Wärmebehandlung und insbesonders fraktionierter Sublimation bzw. Kondensation besonders reine Materialien erhalten werden. Dabei werden Verunreinigungen mittels der Wärmebehandlung insbesondere in große Bereiche von Oxidausscheidungen überführt, die im Sumpf verbleiben und bei der Sublimation nicht mitgerissen werden. Dies ermöglicht eine erhöhte Trennwirkung und damit eine Verbesserung der Reinheit des Ausgangsmaterials. Überraschenderweise gilt dies sowohl für Pulver, Granulat oder auch scherbenförmiges Ausgangsmaterial.

Die einzustellende Temperhaltetemperatur beträgt erfindungsgemäß mindestens 1000°C, vorzugsweise mindestens 1050°C, wobei mindestens 1080°C bzw. 1100°C besonders bevorzugt sind. Ganz besonders bevorzugt ist ein Tempern oberhalb 1200°C, wobei oberhalb 1210°C am meisten bevorzugt ist. Als obere Tempergrenze sollte 1415°C vorzugsweise 1370°C nicht überschritten werden. Die Obergrenzen betragen maximal 1360°C, wobei 1350°C bevorzugt ist. Zweckmäßige Obergrenzen betragen erfindungsgemäß maximal 1300°C, wobei eine maximale Temperatur von 1250°C bzw. 1200°C in den meisten Fällen ausreichend ist. Erfindungsgemäß hat es sich auch als vorteilhaft erwiesen, dass während der Haltezeit möglichst keine oder nur minimale Temperaturunterschiede im Kristall auftreten, d. h. dass die Temperatur über das gesamte Kristallvolumen hinweg möglichst gleich bzw. homogen ist.

Das Tempern wird vorzugsweise bei mindestens 1000°C durchgeführt, wobei die jeweils gewählte Tempertemperatur mindestens 50, vorzugsweise 65 und insbesondere mindestens 75 Stunden gehalten wird. Besonders bevorzugte Haltezeiten betragen mindestens 80 Stunden.

Mit dem erfindungsgemäßen Verfahren wurde nun gefunden, dass sich hochhomogene, laserstabile und streuungsfreie bzw. streuungsarme großvolumige Kristalle dadurch herstellen lassen, dass Kristallmaterial nicht direkt aus der Dampfphase auf einen gekühlten Kristallkeim abgeschieden wird, sondern dass sich großvolumige Kristalle auch mit den klassischen GSM-Verfahren (Gradient Solidification Method) in bislang nicht erreichbarer Qualität und Ausbeute herstellen lassen, wenn das $CaF_2$-Material zuvor bei einer Temperatur von mindestens 1200°C im Vakuum bei einem Druck von höchsten $5*10^{-4}$ ppm verdampft und bei einer Temperatur von mindestens 500°C kondensiert wird.

Bevorzugte Drücke betragen dabei mindestens $10^{-7}$ bzw. $5*10^{-7}$ mbar, und insbesondere mindestens $5*10^{-6}$ bzw. $10^{-6}$ mbar, wobei $5*10^{-5}$ mbar bevorzugt ist. Bevorzugte Höchstdrücke betragen dabei $3*10^{-4}$ mbar, wobei $10^{-4}$ mbar bevorzugt ist. Die Verdampfung selbst wird in einer möglichst sauerstofffreien Atmosphäre durchgeführt, wobei der Gehalt an Sauerstoff vorzugsweise < 5 ppm, insbesondere < 3 ppm ist, wobei < 2 ppm besonders bevorzugt ist. Ganz besonders bevorzugt sind Sauerstoffgehalte von < 1 ppm (in Mol%), wobei < 0,5, insbesondere < 0,1 ppm ganz besonders bevorzugt ist.

In einer weiteren erfindungsgemäßen Ausführungsform wird die Verdampfung des $CaF_2$-Materials unter einem Schutzgas, insbesondere einem Inertgas durchgeführt. Bevorzugte Inertgase sind Helium und Argon. Des weiteren ist eine Verdampfung unter einem reaktiven Gas , insbesondere Wasserstoff erfindungsgemäß durchführbar. Auch Stickstoff ist als Inertgas verwendbar, wenn seine Reinheit wenigsten 99,99999 beträgt.
Eine erfindungsgemäß bevorzugte Verdampfungstemperatur beträgt mindestens 1100°C, wobei Temperaturen von mindestens 1150°C bevorzugt sind. Übliche im erfindungsgemäßen Verfahren verwendete Verdampfungstemperaturen betragen mindestens 1200 bzw. mindestens 1240°C.

Zur Gewinnung des im erfindungsgemäßen Verfahren eingesetzten Rohmaterials wird das $CaF_2$ aus der Dampfphase an einem Kollektor bei mindestens 500°C , insbesondere bei mindestens 600°C aus der Dampfphase abgeschieden. Vorzugsweise liegt die Kondensatortemperatur mindestens 20°C, insbesondere mindestens 30°C unterhalb der Verdampfungstemperatur. Besonders bevorzugte Kondensationstemperaturen liegen 40°C bis 60°C, insbesondere ca. 50°C unterhalb der Verdampfungstemperatur. Auch wenn es nicht unbedingt notwendig ist, hat es sich als zweckmäßig erwiesen, Kondensationstemperaturen zu verwenden, die höchstens 200°C, insbesondere höchstens 150°C bzw. 100°C unterhalb der Verdampfungstemperatur liegen, wobei Temperaturen von höchstens 80°C besonders bevorzugt sind.

In einer weiteren bevorzugten Ausführungsform wird im erfindungsgemäßen Verfahren ein zweiter Materialkondensator eingesetzt, der vom Ort der Verdampfung bezogen auf den Dampf- bzw. Diffusionsweg des verdampften Materials weiter entfernt vom Verdampfungsort liegt als der erste Materialkondensator. Dieser zweite Materialkondensator weist üblicherweise eine geringereTemperatur auf als der erste Kondensator, wobei sich hier Betriebs- bzw. Kondensationstemperaturen von mindestens 20°C, insbesondere mindestens 30°C Differenz unterhalb der Temperatur des ersten Kondensators als zweckmäßig erwiesen haben. Besonders bevorzugt sind hier Temperaturen von mindestens 40°C bis 60°C, insbesondere ca. 50°C unterhalb der ersten Kondensatortemperatur. Als Maximaldifferenzen haben sich hier ebenfalls Temperaturunterschiede von insbesonders maximal 200°C bzw. 150°C, insbesonders höchstens 100°C als besonders zweckmäßig erwiesen, wobei Temperaturen von höchstens 80°C besonders bevorzugt sind.

Das erfindungsgemäße Verfahren wird zweckmäßigerweise in einer geschlossenen evakuierbaren Anlage durchgeführt. Diese Anlage enthält ein Gefäß mit einer Verdampfungs- und Kondensationskammer. Das Gefäß selbst umfaßt ein die Kammer definierendes Gehäuse und einen öffenbaren Verschluss, insbesondere einen Deckel, über den das Innere der Kammer zur Beschickung und zur Entnahme von Material zugänglich ist. Dieses Gehäuse, insbesondere der Deckel, weist eine kleine Öffnung auf, durch welche das Innere der Kammer mit der Anlage kommuniziert und durch welche das Kammerinnere evakuiert werden kann. Diese Öffnung weist üblicherweise einen geringen Durchmesser auf, so dass zwar beim Evakuieren der Anlage auch im Kammerinneren ein Vakuum angelegt werden kann, jedoch in der Gasphase vorliegendes $CaF_2$-Material, wenn überhaupt, nur zu einem geringen Teil austreten kann. Der Verdampfer selbst ist mittels einer Heizvorrichtung versehen und kann vorzugsweise gezielt auf eine gewünschte Temperatur erhitzt werden. In der Anlage befindet sich in einer vom Verdampfungsort entfernten Stelle ein Materialkondensator, wobei Materialkondensator und Verdampfer durch eine leicht zu ermittelnde Dampfdiffusionsstrecke (erste Diffusionsstrecke) getrennt sind. Der Kondensator ist ebenso wie der Verdampfer vorzugsweise plattenförmig ausgestaltet und weist eine geringere Temperatur als der Verdampfer auf. Vorzugsweise ist der Kondensator ebenfalls heizbar und wird auf eine geringere Temperatur eingestellt als der Verdampfer. Je nach Ausgestaltung hat es sich in manchen Fällen auch als zweckmäßig erwiesen, den Kondensator zusätzlich mit einem Kühlmechanismus zu versehen. In einer bevorzugten Ausführungsform ist hinter dem Kondensator ein weiterer zweiter Kondensator und dahinter in besonders bevorzugten Ausführungsformen ein dritter Kondensator angeordnet. Dabei ist der zweite Kondensator vom ersten Kondensator über eine Diffusionsstrecke beanstandet, die zweckmäßigerweise 20 - 80% der ersten Diffusionsstrecke beträgt. Die dritte Diffusionsstrecke zwischen zweitem und drittem Kondensator sowie weitere ggf. nachgeschaltete Strecken zu zusätzlichen Kondensationseinheiten, die ggf. auch Kondensationseinheiten für früh abdampfende Verunreinigungen sein können, beträgt etwa die gleiche Strecke wie die vorliegenden.

In einer weiteren erfindungsgemäß bevorzugten Ausführungsform wird das Ausgangsmaterial in einer ersten Verfahrensstufe auf eine Verdampfungstemperatur von 1400°C, vorzugsweise auf eine Verdampfungstemperatur von maximal 1350°C, insbesondere 1300°C erwärmt und nach Anlegen eines Vakuums solange gewartet bis mindestens 2 Gew.-%, vorzugsweise mindestens 5 Gew.-%, insbesondere mindestens 10 Gew.-% des Ausgangsmaterials verdampft sind. Während dieser Zeit werden vorzugsweise die Kondensatorebenen auf die gleiche Temperatur wie der Verdampfer erwärmt, um ein Abscheiden des vorab verdampften Materiales zu verhindern. Eine Abscheidung dieses Materials findet vorzugsweise an einem separaten Kondensator (Vorlaufkondensator)statt, der in einer speziellen Ausführungsform außerhalb der Verdampfungskammer liegt. Prinzipiell ist es jedoch auch möglich, diesen Vorlaufkondensator in der Kammer selbst anzuordnen. Im Verdampfungsgefäß der Anlage wird während der Verdampfung und der Kondensation des $CaF_2$-Materials ein $CaF_2$-Dampfdruck von mindestens 0,005 Pa, insbesonders mindestens 0,01 Pa und höchstens 0,4 Pa, insbesonders höchstens 0,3 Pa eingestellt. Eine besonders bevorzugte Unter- bzw. Obergrenze beträgt 0,0115 Pa bzw. 0,266 Pa. Außerhalb der Verdampfungskammer, aber innerhalb der gesamten Anlage, welche das Gefäß umfaßt bzw. umschließt, herrscht üblicherweise ein Druck von höchstens $5*10^{-4}$ mbar, wobei Drücke von höchstens $10^{-4}$ mbar besonders bevorzugt sind. Zweckmäßige Mindestdrücke betragen $10^{-7}$, insbesondere $10^{-6}$ mbar, wobei $10^{-5}$ mbar bevorzugt ist. Mit diesem Druck bzw. Vakuum ist das Innere der Gefäß- bzw. Abdampf- und Kondensationskammer über eine kleine Öffnung zur Evakuierung verbunden.

Die Kondensation des Materials erfolgt bei Temperaturen, bei denen unerwünschte Restsubstanzen, wie z. B. noch verbliebene Scavengerprodukte sich noch nicht abscheiden. Solche Temperaturen sind abhängig vom jeweils gewählten Druck im Vakuum und vom Fachmann leicht zu ermitteln. Besonders bevorzugt ist es, das Material in einem Temperaturgradienten abzuscheiden und so gegebenenfalls unterschiedliche Reinheitsgrade zu gewinnen. Ein solcher Temperaturgradient kann kontinuierlich oder aber vorzugsweise mittels mehrerer hintereinander geschalteter Kondensationsbereiche mit zweckmäßigerweise unterschiedlichen Temperaturniveaus erfolgen. Vorzugsweise werden mindestens 2, insbesonders mindestens 3 solche Bereiche verwendet.

Erfindungsgemäß werden bevorzugt größere Kristallplatten, insbesonders gebrauchte und/oder Abfallprodukte aus vorangegangenen Zuchtversuchen als Ausgangsmaterial verwendet. Derartige Kristallplatten können sowohl in ein- als auch polykristalliner Form vorliegen. Dabei ist es bevorzugt, derartige Platten oder Scherben vor ihrer Verwendung zu waschen, um äußere störende Verunreinigungen wie NaCl und/oder Fette sowie Luftverschmutzungen und Oxidationsprodukte insbesonders Hydroxide, Sulfate, Carbonate und Nitrate etc., die an der Oberfläche vorliegen, zu entfernen. Dabei werden die Scherben oder Platten in einem vorzugsweise wässrigen Medium gewaschen. Ein derartiges wässriges Medium ist vorzugsweise eine wässrige tensidische Lösung, wobei nichtionische Tenside bevorzugt sind. Prinzipiell ist es erfindungsgemäß auch möglich, Amphotenside sowie ggf. auch Kationentenside insbesondere mit fluoridischem Gegenion zu verwenden. Vorzugsweise ist die erfindungsgemäß verwendete tensidische Lösung nicht schäumend.

Bevorzugte Tenside sind beispielsweise Aminoalkohole wie beispielsweise 2-Amino-2-Methylpropanol, welches unter dem Handelsnamen Vigon A 200 kommerziell erhältlich ist, oder andere beispielsweise unter dem Handelsnamen Neodisher EM erhältliches Tensid.

Nach dem Waschen werden die Scherben getrocknet, was vorzugsweise bei Temperaturen oberhalb 50°C, insbesonders oberhalb 60°C und vorzugsweise oberhalb 80°C geschieht. Dabei ist es bevorzugt, die Trocknung unter Vakuum, ggf. unter Schutzgas durchzuführen.

Nach dem Waschen und Trocknen werden die Scherben zerkleinert, was beispielsweise durch Schlagbeanspruchung eingeleitete Bruchvorgänge geschehen kann. Die dabei erzeugten Scherbenteile weisen ein Größe von 0,1 bis 10 cm auf und typischerweise 0,5 bis 5 cm, bei einem $d_{50}$ von 0,5 - 3 cm, vorzugsweise 1 - 2 cm.

Das erfindungsgemäße Verfahren erzeugt Vorprodukte die eine Herstellung von Kristallen mit den an sich bekannten Verfahren nach der sog. Gradientenverfestigungsmethode (gradient solification method (GSM)) möglich machen. Weitere übliche bekannte, im industriellen Maßstab durchführbare Verfahren sind beispielsweise das Bridgman-Stockbarger-Verfahren, das Vertical-Gradient-Freeze-Verfahren, das Nacken-Kyropoulos-Verfahren und das Czochralski-Verfahren sowie Varianten dieser Verfahren. Dabei wird jeweils polykristallines Material in einem Tiegel aufgeschmolzen und anschließend die Schmelze langsam, vorzugsweise mittels eines Impfkristalles, in gerichteter Weise erstarren gelassen. Anschließend wird bei all diesen Verfahren langsam abgekühlt, um Kristalle mit bereits geringen thermischen Verspannungen zu erhalten. Alle mit obigen Verfahren erhaltenen Kristalle, Kristallfragmente sowie polykristallines Pulver aus CaF2 sind als Ausgangsrohstoff für das erfindungsgemäße Verfahren geeignet.

Die Erfindung betrifft auch großvolumige Kristalle, die mit dem erfindungsgemäßen Verfahren erhältlich sind. Die erfindungsgemäßen Kristalle weisen eine hohe Laserstabilität, eine hohe Homogenität sowie auch nach dem Tempern eine geringe Streuung auf. Darüber hinaus zeigen sie auch eine geringere Spannungsdoppelbrechung.

Die erfindungsgemäßen Kristalle weisen einen BSDF-Wert von $< 5*10^{-7}$, insbesonders $< 4*10^{-7}$ auf. Diese Werte waren bislang nicht erhältlich. Ganz besonders bevorzugt erfindungsgemäße Kristalle zeigen einen BSDF-Wert von $< 2$, insbesonders $< 1*10^{-7}$, wobei Werte von $< 4*10-7$ besonders bevorzugt sind. Die Homogenität der Brechung insbesondere die Homogenität-RMS (nach Abzug von 36 Zernike-Koeffizienten)beträgt mindestens $< 5*10-8$, vorzugsweise mindestens $< 2*10-8$, wobei $< 1,5*10-8$ besonders bevorzugt ist. Die Spannungsdoppelbrechung (SDB-RMS) beträgt in (100) sowie in (110) Orientierung bzw. Richtung vorzugsweise $< 1$ nm/cm, insbesonders $< 0,35$ nm/cm, wobei $< 0,3$ nm/cm besonders bevorzugt ist. In (111)-Richtung beträgt der SDB-RMS-Wert üblicherweise $< 0,2$ nm/cm, vorzugsweise $< 0,15$ nm/cm und insbesonders $< 0,08$ nm/cm. Bei der Bestimmung der Laserbeständigkeit zeigen die erfindungsgemäßen Kristalle bei einer Bestrahlung von $10 \times 10^9$ Pulsen mit einem Laser der Wellenlänge 193 nm und einer Energiedichte von 10 mJ/cm$^2$ keine Änderung des $k_0$-Wertes

Die erfindungsgemäßen Kristalle weisen nach der Zucht vorzugsweise einen Durchmesser von mindestens 20 cm, vorzugsweise mindestens 30 cm, sowie eine Höhe von mindestens 10 cm, vorzugsweise mindestens 20 cm auf. Besonders bevorzugt sind Durchmesser von mindestens 35 cm bzw. 40 cm und Höhen von mindestens 25 cm bzw. 30 cm. Die Kristalle haben vorzugsweise einen Sauerstoffgehalt von $< 6$ ppm, insbesonders $< 3$ ppm, wobei $< 1$ ppm besonders bevorzugt ist. Der Kohlenstoffgehalt liegt vorzugsweise $< 18$ ppm und insbesonders $< 10$ ppm. Besonders bevorzugt sind C-Gehalte $< 8$ ppm.

Die Erfindung betrifft auch die Verwendung der so erhaltenen Kristalle für optische Zwecke, insbesonders als Rohling bzw. Halbzeuge für optische Elemente. Eine bevorzugte Anwendung der so erhaltenen Kristalle betrifft die Mikrolithographie, üblicherweise die Mikrolithographie $< 250$ nm, insbesonders bei 248 nm bzw. bei 193 nm und vorzugsweise bei 157 nm.

Die Erfindung betrifft auch die Verwendung derartiger Kristalle für optische Elemente, insbesonders Prismen und Linsen, die in optischen Anordnungen, insbesonders Objektiven, verwendet werden. Die erfindungsgemäßen Kristalle finden daher insbesondere Verwendung in der Mikrolitho- und Photographie, insbesonders zur Herstellung von Steppern, Exzimerlasern, Wafern, Computerchips, sowie integrierten Schaltungen und elektronischen Geräten, die solche Schaltungen und Chips enthalten.

Die Erfindung soll anhand der folgenden Beispiele näher erläutert werden.

Es zeigen:

Fig. 1 eine geschlossene evakuierbare Sublimationsanlage

Fig. 2 zeigt ein Absorptionsspektrum aus erfindungsgemäßen Kristallen sowie aus Kristallen des Standes der Technik.

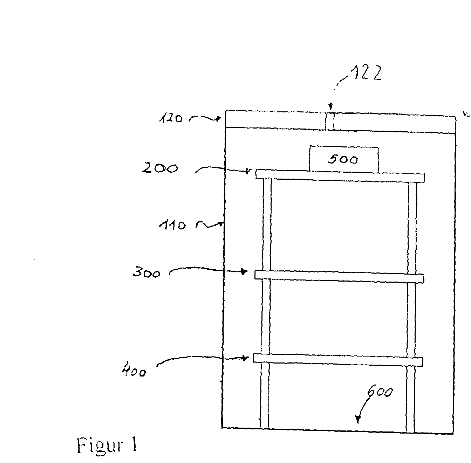

Eine Vakuumsublimationsanlage zur Durchführung des erfindungsgemäßen Verfahrens ist beispielhaft in Fig. 1 dargestellt. Die Anlage umfaßt ein Gefäß oder Gehäuse 100 mit einer Gefäß- oder Gehäusewand und -boden 110 und einem Deckel 120. Der Deckel 120 ist vom der Gehäusewand und dem Boden 110 abnehmbar und weist eine kleine ausreichend große Öffnung in Form einer Bohrung auf. Das Gefäß selbst definiert eine Verdampfungs- und Kondensationskammer 150, die über die Öffnung 122 mit dem äußeren, d. h. einem Vakuumvorrat (nicht dargestellt) kommuniziert. Als Vakuumvorrat kann ein weiteres Gehäuse innerhalb der Anlage dienen, in welchem das Gehäuse 100 eingehaust ist. In der Kammer 110 sind heizbare, ggf. auch kühlbare Ebenen bzw. Wannen 200, 300, 400 angeordnet. Auf der oberen Ebene 200 ist das zu verdampfende Gut 500 angeordnet. Wird nun die Ebene bzw. Wanne 200 mittels einer Heizvorrichtung (nicht dargestellt) auf die Betriebstemperatur erwärmt, dann verdampft das Material 500 und scheidet sich auf der darunter liegenden Ebene 300 ab, die eine geringere Temperatur als die Verdampfungsebene 200 aufweist. Die Kondensationsebene 300 ist von der Verdampfungsebene 200 durch einen Diffusionsweg D1 entfernt. Unterhalb der Kondensationsebene 300 befindet sich eine zusätzliche Kondensationsebene 400, welche restliches an der Ebene 300 nicht abgeschiedenes verdampftes Material 500 kondensiert. Auf der untersten Ebene kann ggf. eine Kondensations- bzw. Auffangwanne für bereits bei tieferen Temperaturen verdampftes unerwünschtes Material angeordnet sein (nicht dargestellt). Prinzipiell weisen die nacheinander geschalteten Kondensationsebenen bzw. -wannen eine jeweils geringere Temperatur als die darüber liegende Ebene auf, so dass hier eine fraktionierte Abscheidung des verdampften Materiales 500 erfolgt. Dabei ist das auf der ersten Ebene 300 kondensierte Material üblicherweise das reinste Material, welches vorzugsweise im erfindungsgemäßen Verfahren eingesetzt wird. Das so erhaltene Material ist üblicherweise bereits derart grobkörnig, d. h. ein- oder polykristallin, dass es bei einer anschließenden Verwendung zur Herstellung einer Schmelze keine vorherige Kompaktierung mehr benötigt, d. h. der Verfahrensschritt zur Herstellung eines Ingots kann im erfindungsgemäßen Verfahren entfallen.

Beispiel 1:

Es werden aus Abfall von unbrauchbaren Kristallzüchtungen sowie aus Verschnitt bei der Linsenherstellung angefallenen Altscherben in Wäschekörbe eines Waschautomaten Miele Waschautomat Typ G7827eingelegt und in einem Abstand von mindestens 1 cm voneinander in den Spülkörben angeordnet. Auf diese Weise wird gewährleistet, dass die Scherbenstücke während des Waschgangs vollständig umspült werden. Scherben, die auf ihrer Außenseite noch Markierungen wie beispielsweise Filzstiftmarkierungen aufweisen, werden durch Abschlagen dieser Bereiche hiervon befreit. Der Waschkorb wird mit einer Scherbenmasse von 12 bis 18 Kg beladen und in den Spülwagen gestellt und anschließend mit einem Transferwagen durch den Automaten gefahren. Am Waschautomaten wird anschließend ein Waschprogramm (Waschprogramm Nr. 20) ausgewählt und nach Beendigung des Programms (90 Minuten) wird der Spülwagen entnommen. Während des Spülens wird darauf geachtet, dass die Leitfähigkeitsmessung des Wassers im vorbestimmten Bereich verbleiben um ggf. rechtzeitig eine neue Entsalzungspatrone einzusetzen.

Nach dem Waschen werden die Scherben in Trocknungskörbe umgeschichtet und dabei einer ersten visuellen Begutachtung unterzogen. Scherben, denen Farbreste anhaften, werden aussortiert und ggf. nochmal durch Abschlagen gereinigt. Danach werden die Körbe in einem Vakuumofen getrocknet. Dabei werden üblicherweise nach jedem Waschgang drei Trocknungszyklen durchgeführt. Während des Trocknens wird der Vakuumtrockenofen auf 90°C aufgeheizt und bei dieser Temperatur eine Stunde gehalten. Das angelegte Vakuum liegt im Bereich von 10-2 mbar. (Trockenofen Binder Typ VD 115).Nach dem Trocknen werden die Scherben nochmals einer visuellen Kontrolle unterzogen und wie zuvor Farbanhaftungen durch Abschlagen entfernt. Danach werden die Scherben mit einer Kantenlänge > 5 cm mit einem leichten Hammerschlag zerkleinert. Dies ist vor allem deshalb möglich, weil durch den Wasch- und Trocknungsprozess die Scherben viele Spaltrisse aufweisen. Die Bruchstücke werden dann in eine Kunststoffkiste gefüllt und in Mengen von 5 kg mitsamt der Kiste in einen Folienbeutel mittels eines Vakuumschweißgeräts eingeschweißt und so bis zu ihrer weiteren Verwendung gelagert.

Beispiel 2:

Einstufiges Sublimationsverfahren

In eine Vakuumsublimationsanlage gemäß Fig. 1 wird auf die Verdampfungs- oder Scherbenebene 200 5 kg der zu der vorgereinigten Rohscherben 500 eingetragen und nach Verschließen des Deckels 120 und Anlegen eines Anlagevakuums von $10^{-4}$ bis $10^{-5}$ mbar eine Prozesstemperatur von 1100°C bis 1250°C gehalten. Dabei weisen die Kondensatoren 300, 400, 600 der drei folgenden Kondensationsebenen pro Ebene eine um jeweils 50°C geringere Temperatur auf als die darüberliegende. Dabei erfolgt die Sublimation von oben nach unten und das Sublimat wandert entlang der Wand 110 entsprechend der Temperatur auf die einzelnen Sublimationsebenen 300, 400, 600. Dabei findet sich das beste Material auf der oberen Kondensationsebene 300. Innerhalb des $CaF_2$-Verdampf- und Kondensationsraumes beträgt 0,0115 bis 0,266 Pa. Zur Abdampfung bzw. von ca. 90% der Masse der Rohscherben 500 wurde bei einer Temperatur von 1250°C ca. 72 Stunden benötigt.

Beispiel 3: Zweistufiges Verfahren.

Hierbei wird wie zuvor beschrieben 5 kg von Rohscherben 500 in den Verdampferraum 150 eingebracht und in einer ersten Prozessphase bei Temperaturen zwischen 1100°C und 1250°C für 18 Stunden gehalten. Während dieser Zeit werden sowohl die Verdampferebene 200 als auch die Kondensatoren 300, 400, 600 bei gleichen Temperaturen gehalten, um ein Kondensieren von vorab verdampften mit niedrig dampfenden Verunreinigungen versehenen Rohmaterial zu vermeiden. Es hat sich hierzu auch als zweckmäßig erwiesen, diese Phase ggf. bei einem geringeren Vakuum, d. h. bei höheren Drücken durchzuführen als bei der späteren Verdampfung. Die eigentliche Verdampfung erfolgt anschließend bei einer erhöhten Temperatur zweckmäßigerweise oberhalb 1250°C über einen Zeitraum von 56 Stunden. Auf diese Weise wird zwar die Ausbeute verringert (nur 75% der Rohmasse), jedoch der Aufreinigungsgrad der im Kondensator abgeschiedenen Materials erhöht sich beträchtlich.

Der Verdampfer 200 wird über einen Heizer (nicht dargestellt) erhitzt, der den Verdampfertiegel bzw. die Ebene in seinem gesamten Umfang erwärmt. Die Temperatur der Kondensatoren 200, 300, 600 wird anschließend durch separate Heiz- und Kühlelemente (ebenfalls nicht dargestellt) genau eingestellt.

Beispiel 4: Optische Qualitäten der erfindungsgemäß erhaltenen Kristalle

Züchtung von Kristallen

Um die Auswirkung einer derartigen Vorgehensweise auf fertige Kristalle zu bestimmen, die aus einer Schmelze aus gemäß den Beispielen 1 - 3 gewonnenem Material hergestellt werden, wurden kleine Testkristalle gezüchtet und mit vergleichbar hergestellten Kristallen aus unbehandelten Scherben und aus handelsüblichen bereits gereinigtem synthetischen hochreinen $CaF_2$-Pulver verglichen. Dabei zeigte sich, dass sich aus den erfindungsgemäß erhaltenen Kristallen wesentlich hochwertigere optische Elemente herstellen lassen als dies mit den Materialen des Standes der Technik möglich ist. Die erfindungsgemäß erhaltenen Kristalle zeigen nicht nur eine höhere Laserstrahlungsfestigkeit, sondern auch eine deutlich geringere Neigung zur Lichtstreuung. Die Ergebnisse sind in der folgenden Tabelle I dargestellt.

Dabei sind E1 - E8 erfindungsgemäße erhaltene Kristallproben und V1 - V4 Kristalle, die aus handelsüblichen $CaF_2$-Pulver erhalten wurden.

| Probe | Streuklasse | Eingangsleistung | Mittelwert BSDF | Anzahl/Lage Messpunkte | Bemerkung |
|---|---|---|---|---|---|
| E1 | 0 | | 1,45E-07 | 5 verschiedene MP | sehr homogen! |
| E2 | 0 | 10,6...11,5 | 1,97E-07 | 5 verschiedene MP | |
| E3 | 0 | | 3,38E-07 | 5 verschiedene MP | sehr homogen! |
| E4 | 0 | | 2,06E | 5 verschiedene MP | homogene Streuung! |
| E5 | 0-1 | 9,4...9,7 | 8,65E-07 | | |
| E6 | 0-1 | 12,0...12,2 | 1,73E-07 | | Wolken |
| E7 | 0-1 | 8,7 | 3,29E-06 | | Wolken |
| E8 | 0-1 | 6,1...6,2 | 3,79E-07 | 5 verschiedene MP | homogene Streuung! |
| V1 | 0-1 | 8,8...8,9 | 9,57E-07 | | Wolken |
| V2 | 0-1 | 10,6...11 | 5,43E-07 | | Wolken |
| V3 | 0-1 | 10,1 | 1,26E-06 | 5 verschiedene MP | Wolken |
| V4 | 0-1 | 11,2...11,3 | 5,26E-07 | 5 verschiedene MP | |

Untersuchungen zur Spektrenausbildung nach Röntgen-bestrahlung

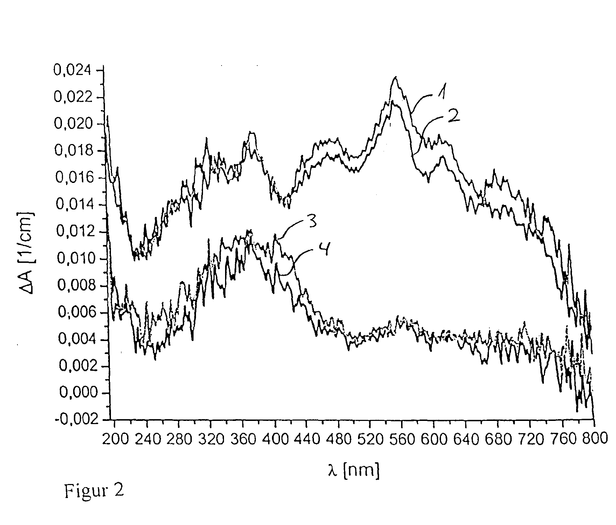

Es wurde das Differenzspektrum nach Röntgendamage im Wellenlängenbereich zwischen 320 und 800 nm untersucht. Dabei wurde das Material mit Röntgenstrahlung mit einer Energiedichte von ca. 20mJ/cm$^2$ bestrahlt. Figur 2 zeigt ein Absorptionsspektrum von 200 - 800 nm, welches aus den Kristallen erhalten wurde, die aus Rohscherben sowie aus dem erfindungsgemäß erhaltenen Material gewonnen wurde. Dabei wurde ein Differenzspektrum vor und nach der Bestrahlung durchgeführt. Wie sich der Figur entnehmen lässt, sind die Kurven 1 und 2 (nichterfindungsgemäß hergestellte Kristalle) deutlich schlechter als die gemäß dem Beispiel 1 bzw. dem Beispiel 2 erhaltenen erfindungsgemäßen Kristalle. Hierbei ist die Kurve 3 gemäß Beispiel 1 und Kurve 4 an einem Kristall gemäß Beispiel 2 erhalten worden.

Die erfindungsgemäß erhaltenen Ergebnisse sind umso überraschender, als diese mit vorbenutztem und als unbrauchbaren Material erhalten werden, wohingegen die aus synthetisch hochreinem Ausgangsmaterial gemäß dem Stand der Technik keine derartig guten Kristalle erhältlich sind.

**EP 1 566 469 A2**

**Patentansprüche**

1. Verfahren zur Herstellung von bei erhöhter Temperatur temperbaren $CaF_2$-Einkristallen mit geringer Streuung sowie geringer Brechzahlunterschiede und geringer Anzahl an Kleinwinkelkorngrenzen, umfassend Züchten des Kristalles aus einer $CaF_2$-Materialschmelze durch Abkühlen der Schmelze sowie nachfolgendes Tempern, **dadurch gekennzeichnet, dass** man $CaF_2$-Rohmaterial bei einer Temperatur von mindestens 1100°C in einem Vakuum bei höchstens $5*10^{-4}$ mbar verdampft und bei einer Temperatur von 500 bis 1280°C kondensiert und aus diesem Kondensat die $CaF_2$-Materialschmelze herstellt, wobei man vor der Überführung in die Gasphase das $CaF_2$-Material für mindestens 5 Stunden bei Temperaturen zwischen 1000 und 1250°C wärmebehandelt.

2. Verfahren nach Anspruch 1, **dadurch gekennzeichnet, dass** das nachfolgende Tempern bei mindestens 1000 °C erfolgt.

3. Verfahren nach einem der vorhergehenden Ansprüche, **dadurch gekennzeichnet, dass** man $CaF_2$-Kristalle verwendet, die aus Abfall von verbrauchten $CaF_2$-Kristallen gewonnen werden.

4. Verfahren nach einem der vorhergehenden Ansprüche **dadurch gekennzeichnet, dass** man das $CaF_2$-Material vor der Überführung in die Gasphase aufschmilzt und Verunreinigungen sedimentieren oder unaufgefangen verdampfen läßt.

5. Verfahren nach einem der vorhergehenden Ansprüche **dadurch gekennzeichnet, dass** die Temperatur am Kondensator mindestens 600°C beträgt.

6. Verfahren nach einem der vorhergehenden Ansprüche **dadurch gekennzeichnet, dass** die Kondensation in einer ersten Stufe bei einer Temperatur von mindestens 800°C und in einer darauf folgenden kälteren zweiten Stufe von mindestens 600°C erfolgt.

7. Verfahren nach einem der vorhergehenden Ansprüche **dadurch gekennzeichnet, dass** das Verfahren unter Inertgas durchgeführt wird.

8. Verfahren nach einem der vorhergehenden Ansprüche **dadurch gekennzeichnet, dass** man vor Beginn der Verdampfung und Kondensation das Material aufschmilzt und mindestens 12 Stunden bei einer Temperatur < 1500°C erwärmt.

9. Verfahren nach einem der vorhergehenden Ansprüche, **dadurch gekennzeichnet, dass** die CaF2-Kristalle vor ihrer Verwendung mittels einer wässrigen Tensidlösung aus entionisiertem Wasser vorgewaschen und getrocknet werden.

10. Verfahren nach Anspruch 9, **dadurch gekennzeichnet, dass** das Tensid ein nicht-ionisches und/oder amphoteres Tensid ist.

11. Großvolumiger, bei erhöhter Temperatur temperbarer $CaF_2$-Einkristall mit geringer Streuung sowie geringen Brechzahlunterschieden und geringer Anzahl von Kleinwinkelkorngrenzen erhältlich durch das Verfahren nach einem der vorhergehenden Ansprüche **dadurch gekennzeichnet, dass** er einen BSDF-Wert von < $1,5*10^{-6}$.

12. Kristall nach Anspruch 9-10, **dadurch gekennzeichnet, dass** der Kristall in 100-Richtung einen RMS-Wert der SDB von < 0,3 nm/cm aufweist.

13. Kristall nach Anspruch 9-12, **dadurch gekennzeichnet, dass** er in 111-Richtung einen RMS-Wert der Homogenität von < 0,025 ppm und/oder einen SDB-PV-Wert von < 0,5 nm/cm und einen SDB-RMS-Wert von < 0,15 nm/cm aufweist und/oder in 110- und/oder 100-Richtung einen SDB-RMS-Wert von < 1 nm/cm und/oder einen SDB-PV-Wert von < 2,5 nm/cm aufweist.

14. Kristall nach Anspruch 10 oder 11, **dadurch gekennzeichnet, dass** er in 100-Orientierung einen SDB-RMS-Wert von < 0,3 nm/cm und einen RMS-Wert der Homogenität nach Abzug von 36 Zernike Koeffizienten von < $1,5 \times 10^{-8}$ aufweist.

15. Kristall nach Anspruch 10 oder 11, **dadurch gekennzeichnet**, das der Kristall einen Sauerstoffgehalt von < 3 ppm, und/oder einen Kohlenstoffgehalt von < 10 ppm, bevorzugt von <8 ppm aufweist.

16. Verwendung der nach einem der Verfahren der Ansprüche 1 - 9 erhaltenen Kristalle sowie der Kristalle nach einem der Ansprüche 10 - 12 als optisches Element, zur Herstellung von Steppern, Excimer-Lasern, Wafern, Computerchips, sowie integrierten Schaltungen und elektronischen Geräte, die solche Schaltungen und Chips enthalten.

Figur 1

EP 1 566 469 A2
```

Figur 2